# EUROPEAN PATENT APPLICATION

(11) **EP 1 634 979 A1**
(43) Date of publication of application: **15.03.2006**
(21) Application number: 04720196.7
(22) Date of filing: 12.03.2004
(51) Int. Cl.: C30B 29/10, G02F 1/09, H01F 1/00

(54) **TRANSPARENT FERROMAGNETIC ALKALI/CHALCOGENIDE COMPOUND COMPRISING SOLID SOLUTION OF TRANSITION METAL OR RARE EARTH METAL AND METHOD OF REGULATING FERROMAGNETISM THEREOF**

(30) Priority: 02.05.2003 JP 2003127602
(71) Applicant: Japan Science and Technology Agency, Kawaguchi-shi, Saitama 332-0012 (JP)
(72) Inventor: YOSHIDA, Hiroshi, Hyogo 666-0111 (JP); SEIKE, Masayoshi, Akashi-shi, Hyogo 674-0081 (JP); SATO, Kazunori, Minoh-shi, Osaka 562-0031 (JP); YANASE, Akira, Nara-shi, Nara 631-0046 (JP)
(74) Representative: Röthinger, Rainer
(86) International application number: PCT/JP2004/003373
(87) International publication number: WO 2004/097081

(57) **Abstract**

Disclosed is a ferromagnetic alkali chalcogen compound capable of providing a completely-spin-polarized transparent ferromagnetic material using an alkali chalcogen compound having light-transparency, and a method of adjusting ferromagnetic properties thereof. The transparent ferromagnetic alkali chalcogenide comprises an alkali chalcogen compound which has an anti-fluorite structure and contains at least one metal element selected from a 3d transition metal element group consisting of Ti, V, Cr, Mn, Fe, Co, Ni and Cu; a 4d transition metal element group consisting of Zr, Nb, Mo, Tc, Ru and Rh; a 5d transition metal element group consisting of Hf, Ta, W, Os, Re and Ir; and a lanthanum-series rare-earth element group consisting of Ce, Pr, Nd, Pm, Sm, Eu, Gd, Tb, Dy, Ho, Er, Tm, Yb and Lu. The selected metal element is incorporated in the alkali chalcogen compound in the form of a solid solution to provide a ferromagnetic characteristic thereto. The ferromagnetic properties are adjusted through control of valence states based, for example, on adjustment of a concentration of each of the metal elements, selection of a combination of two or more of the metal elements, and/or addition of an acceptor and a donor.

## Description

### TECHNICAL FIELD

The present invention relates to a single-crystal alkali chalcogenide capable of achieving a ferromagnetic property using an alkali chalcogenide having wide bandgap and transparency, and a method of adjusting the ferromagnetic property.

In particular, the present invention relates to a transparent ferromagnetic alkali chalcogenide having a large magneto-optical effect and a desired ferromagnetic property, such as a ferromagnetic transition temperature, and a method of adjusting the ferromagnetic property.

### BACKGROUND ART

Alkali chalcogenides have properties of being transparent and colorless, having a large bandgap (Eg) of 3 eV or more and a large exciton binding energy, and exhibiting transparency to light ranging from the visible to ultraviolet region and even to light in the extreme-ultraviolet region. If a ferromagnetic material having a large spin-orbital interaction is obtained using the alkali chalcogenides, it is expected that such a material brings about major breakthrough in fabrications of spin transistors or optical isolators utilizing a spin degree of freedom, or photon devices, such as a photon computer, utilizing coherent spin states, and in developments of devices for quantum information processing.

However, no example of achieving a completely-spin-polarized ferromagnetic state in an alkali chalcogenide doped with a 3d, 4d or 5d transition metal element or a lanthanum-series rare-earth element, or a ferromagnetic state in an alkali chalcogenide having a high ferromagnetic transition temperature (Curie point), has been reported.

### DISCLOSURE OF THE INVENTION

If a single-crystal ferromagnetic thin film having light-transparency and excellent ferromagnetic characteristics is obtained, magneto-optical effects of the thin film can be utilized to achieve an optical isolator necessary for transmitting massive information, or high-density magnetic recording by means of light. Such a thin film also makes it possible to positively utilize light in combination with the charge degree of freedom of an electron and the spin degree of freedom of the electron so as to prepare an electronic magneto-optical material applicable to a device necessary for large-volume/ultrahigh-speed/ultra-energy-saving data transmission in the future. Further, there is a strong need for providing a completely-spin-polarized ferromagnetic material having giant magneto-optical effects and exhibiting ferromagnetic characteristics while maintaining light-transparency.

As described above, if a material having transparency to light in the visible range and stable magneto-optical effect-based ferromagnetic characteristics is obtained using an alkali/ chalcogenide compound, the obtained material can be use in combination with a light-emitting element, such as a semiconductor laser, made of an alkali chalcogenide having a large bandgap energy, to generate circularly-polarized light reflecting magnetic states. This allows applications of a magneto-optical spin-based device utilizing giant magneto-optical effects based on a large spin-orbital interaction to be expanded to optical data communications and spin electronics.

Further, when a ferromagnetic memory based on an alkali chalcogenide is designed to be irradiated with light and be changed in magneto-optical effect using a large circularly-polarized light to be generated depending on magnetic states, as described above, it is required to prepare the alkali chalcogenide in such a manner that it has a desired ferromagnetic characteristic, for example, a ferromagnetic transition temperature (Curie temperature) is set at a value which allows a magnetic state to be changed in response to light irradiation (at a value slightly greater than room temperature).

It is an object of the present invention to provide a transparent ferromagnetic alkali chalcogenide capable of obtaining a completely-spin-polarized ferromagnetic material using an alkali chalcogenide having light-transparency.

It is another object of the present invention to provide a method of adjusting a ferromagnetic characteristic of a ferromagnetic alkali chalcogenide, capable of achieving a completely-spin-polarized ferromagnetic state in a diluted mixed-crystal structure and adjusting the ferromagnetic state, by incorporating one or more 4d or 5d transition metal elements which have a large spin-orbital interaction but no transition to a ferromagnetic state in conventional methods, into the alkali chalcogenide in the form of a solid solution.

The inventors made various researches for obtaining a single crystal having ferromagnetic characteristics, using an alkali chalcogenide having a wide bandgap suitable, particularly, for a light-transparent material, and a large lattice constant. As the result, the inventors found the following facts: a single crystal can be adequately obtained even if a 4d (Zr, Nb, Mo, Tc, Ru or Rh), 5d (Hf, Ta, W, Os, Re or Ir) or 3d (Ti, V, Cr, Mn, Fe, Co, Ni or Cu) transition metal element or a lanthanum-series rare-earth element (Ce, Pr, Nd, Pm, Sm, Eu, Gd, Tb, Dy, Ho, Er, Tm, Yb and Lu) is added (incorporated in the form of a solid solution) through a non-equilibrium crystal growth process at a low temperature to substitute alkali metal ions therewith at up to about 25 at%; a mixed crystal formed by adding of one or more of the above elements to an alkali chalcogenide causes a change in electronic state of the compound to allow a hole or electron to be doped thereinto (allow the number of electrons to be reduced or increased) so as to obtain a ferromagnetic state; and one or more of the above elements incorporated into an alkali chalcogenide in the form of a solid solution can provide the same effect as that of a hole or electron added to a d-electron (each of the above elements can serve as a p-type or n-type dopant by itself). That is, the inventors found that a stable completely-spin-polarized transparent ferromagnetic state can be obtained in an alkali chalcogenide only by the solitary effect of one or more of the above metal elements incorporated thereinto in the form of a solid solution.

In the above group of 4d transition metal elements, only Zr, Nb, Tc, Ru and Rh exhibit ferromagnetic properties, and Mo exhibits spin-glass properties. However, when Mo is doped with a p-type carrier, it will exhibit ferromagnetic spin-glass properties. In the above group of 5d transition metal elements, only Hf, Ta, Re, Os and Ir exhibit ferromagnetic spin-glass properties, and W exhibits spin-glass properties. However, when W is doped with a p-type carrier, it will exhibit ferromagnetic properties. In the above group of 3d transition metal elements, only Ti, V, Mn, Fe, Co, Ni and Cu exhibit ferromagnetic properties, and Cr exhibits spin-glass properties. However, when Cr is doped with a p-type carrier, it will exhibit ferromagnetic properties. In particular, each of the 4d and 5d transition metal elements has a large spin-orbital interaction allowing a large magneto-optical effect to be obtained.

As the result of further researches, the inventors found the following facts: each of the above elements has a high spin state with an electron spin s = 1, 3/2, 2; a ferromagnetic transition temperature of an alkali chalcogenide can be changed by changing a concentration of each of the elements to be added, or selecting a combination of two or more of the above elements, or forming a mixed-crystal structure different in concentration ratio of two or more of the elements to be added, or adding n-type and/or p-type dopants; a ferromagnetic state can be stabilized rather than stabilization of an antiferromagnetic, spin-glass or paramagnetic state, by the above technique; an energy amount in the ferromagnetic state (e.g. an energy amount capable of usually maintaining the ferromagnetic state even though a slight change thereof causes transition to an antiferromagnetic state) can be adjusted by the above technique; and a lower-limit wavelength for transmission of light is varied depending on kinds of the above elements, and two or more of the elements can be selectively added to form a mixed crystal so as to provide a desired light filter function. That is, the inventors found that a single-crystalline alkali chalcogenide having a desired magnetic characteristic and a completely-spin -polarized transparent ferromagnetic state (which means that a bandgap exists only in one of two spin directions, and electrons in the other spin direction are in an itinerant state and is also referred to as "half-metallic ferromagnetic state").

In the completely-spin-polarized transparent ferromagnetic alkali chalcogenide, at least one metal selected from the above 3d, 4d and 5d transition metal elements and the above lanthanum-series rare-earth elements is incorporated in an alkali chalcogenide in the form of a solid solution.

As used in the specification, the term "alkali chalcogenide having an anti-fluorite structure (anti-CaF₂ structure)" means a compound containing an alkali metal (Na, K, Rb, Cs) and a chalcogen atom (O, S, Se, Te), and specifically including K₂S, K₂Se, K₂Te, K₂O, Na₂S, Na₂Se, Na₂Te, Na₂O, Li₂O, Li₂S, Li₂Se, Li₂Te, Rb₂O, Rb₂S, Rb₂Se, Rb₂Te Cs₂O, Cs₂S, Cs₂Se and Cs₂Te.

The above compound has a large lattice constant, and thereby has a weak hybridization between respective orbitals of an impurity and a parent atom. Thus, the alkali metal atom, such as K, Na, Li or Rb can be substituted with each of the above 3d, 4d and 5d transition metal elements and the above lanthanum-series rare-earth elements. Even if the substation is performed at up to about 25 at% through a non-equilibrium crystal growth process at a low temperature, a single crystal with an anti-fluorite structure will be maintained to exhibit anti-fluorite-structure-based completely-spin-polarized ferromagnetic properties while maintaining a transparency of the original alkali chalcogenide.

When at least two metal elements selected from the above 3d, 4d and 5d transition metal elements and the above lanthanum-series rare-earth elements are incorporated in the form of a solid solution, of d and f electrons originated from the transition metal element-impurities are hybridized with atomic orbitals of the compound serving as a matrix to form a narrow impurity band. Thus, large electron-correlation effects and can be obtained, and not just a ferromagnetic state but a completely-spin-polarized transparent ferromagnetic state can be achieved. In this way, as compared to doping of a hole or electron, a ferromagnetic characteristic is changed in a more direct manner to allow a ferromagnetic characteristic, such as a ferromagnetic transition temperature, to be adjusted.

When at least one of n-type and p-type dopants is doped, the doped carrier enters into the narrow impurity band formed in a bandgap. Thus, the number of electrons occupying each of the impurity levels of the d and f electrons of the doped transition metal can be changed, and the ferromagnetic characteristic can be adjusted through control of valence states of the d and f electrons forming the impurity band.

The present invention includes the following methods (1) to (3) for adjusting a ferromagnetic characteristic of the alkali chalcogenide having an anti-fluorite structure:
(1) Adding to the above original alkali chalcogenide at least one metal element selected from the above 3d transition metal elements, or at least one metal element selected from the above 4d transition metal elements, or at least one metal element selected from the above 5d transition metal elements, or at least one metal element selected from the above lanthanum-series rare-earth elements, while adjusting a concentration of the element to be added;
(2) Selecting a combination of at least two metal elements to be selected from one or more of the groups consisting the 3d transition metal element group, the 4d transition metal element group, the 5d transition metal element group; and the lanthanum-series rare-earth element group; and
(3) In addition to the method (1) or (2), adding at least one of an n-type dopant and a p-type dopant, while adjusting a concentration of the dopant to be added.

Specifically, a ferromagnetic transition temperature can be controllably set at a desired value by adjusting the above concentrations (a concentration of each of the above transition metal elements or rare-earth elements and a concentration of each of the dopants), or selecting of a combination of two or more of the above transition metal elements or rare-earth elements. Further, a ferromagnetic state can be stabilized by adding two or more of the above transition metal elements or rare-earth elements to form a mixed crystal so as to adjust an energy amount for stabilizing the ferromagnetic state and to reduce the entire energy amount based on kinetic energy of a hole or electron introduced by the transition metals themselves. Alternatively, the ferromagnetic state can be stabilized by adding two or more of the above transition metal elements or rare-earth elements to form a mixed crystal so as to control a strength and sign of a magnetic interaction between the transition metals, based on a hole or electron introduced by the transition metals themselves.

Further, a desired light-filter characteristic can be obtained in the completely-spin-polarized transparent ferromagnetic alkali chalcogenide by adding two or more of the above transition metal elements or rare-earth elements to form a mixed crystal so as to control a strength and sign of a magnetic interaction between the transition metals, based on a hole or electron introduced by the transition metals themselves, and control a light-transparency, based on solid solution of the transition metal elements.

### BRIEF DESCRIPTION OF DRAWINGS

FIG. 1 is an explanatory diagram showing one example of an apparatus for forming a completely-spin-polarized transparent ferromagnetic single-crystal thin film of the present invention.
FIG. 2 is a graph showing a difference ΔE between the entire energy amount in an antiferromagnetic spin-glass state and the entire energy amount in a ferromagnetic state when a mixed crystal is formed by adding each 4d transition metal element of Zr, Nb, Mo, Tc, Ru and Rh to K₂S.
FIG. 3 is a graph showing changes of a ferromagnetic transition temperature when a concentration of the transition metal to be incorporated into K₂S in the form of a solid solution is changed.
FIG. 4 is an explanatory graph showing changes of a ferromagnetic transition temperature when a mixed crystal is formed by adding two or more of the transition metal elements while changing a ratio of the transition metal elements.
FIG. 5 is an explanatory graph showing changed of a magnetic state when n-type and p-type dopants is added into Nb as one example.
FIGS. 6(a) and 6(b) are graphs showing, respectively, state densities of Nb and Tc in K₂S in a half metallic state (the up-spin corresponds to a metallic state, and the down-spin corresponds to a solid state).
FIGS. 7(a) and 7(b) are graphs showing, respectively, state densities of Ta and Os in K₂S in a half metallic state (the up-spin corresponds to a metallic state, and the down-spin corresponds to a solid state).

### BEST MODE FOR CARRYING OUT THE INVENTION

With reference to the drawings, a completely-spin-polarized transparent ferromagnetic alkali chalcogenide of the present invention and an adjustment method for a ferromagnetic characteristic thereof will now be described. The completely-spin-polarized transparent ferromagnetic alkali chalcogenide of the present invention comprises an alkali chalcogenide which has an anti-fluorite structure and contains at least one metal element selected from the aforementioned 3d, 4d and 5d transition metal elements and the aforementioned lanthanum-series rare-earth elements, in the form of a solid solution.

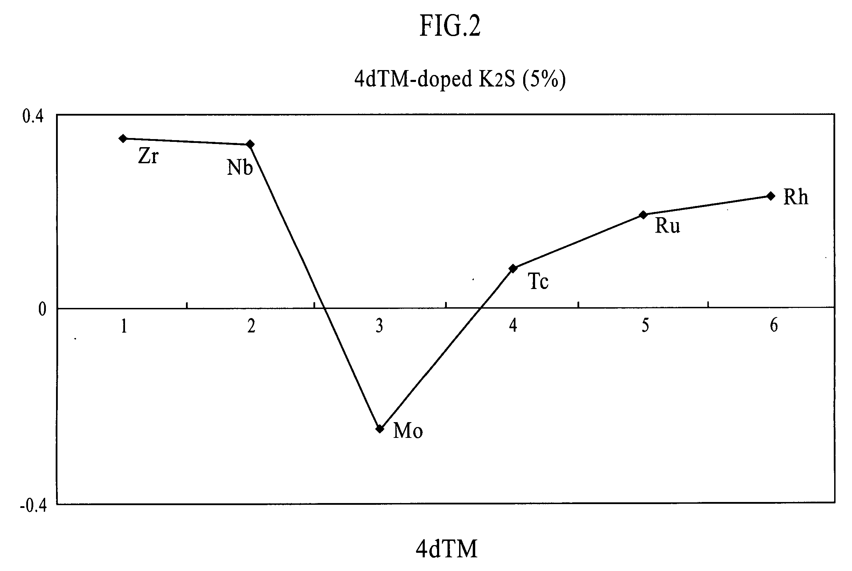

As described above, as the result of various researches for obtaining a completely-spin-polarized transparent ferromagnetic material using K₂S which is one of alkali chalcogenides having an anti-fluorite structure, the inventors found that K₂S exhibits ferromagnetic properties simply by incorporating only each of the 4d transition metal elements consisting of Zr, Nb, Mo, Tc, Ru and Rh in the form of a solid solution, based on a difference ΔE between the entire energy amount in an antiferromagnetic spin-glass state and the entire energy amount in a ferromagnetic state, as shown in FIG. 2. In FIG. 2, a positive value indicates that the ferromagnetic state is stable, and a negative value indicated that the antiferromagnetic spin-glass state is stable.

While a ratio of the solid solution to K in K₂S is set at 5 at% in this example, K₂S exhibits ferromagnetic properties even if the ratio is set at several at%, and the ratio may be increased without adverse affects on crystallinity and transparency. Specifically, the ratio is set in the range of 1 to 99 at%, preferably 1 to 25 at%, to facilitate obtaining sufficient ferromagnetic properties. The number of the transition metal elements to be added is not limited to one, but two or more of the transition metal elements may be added to form a mixed crystal, as described later.

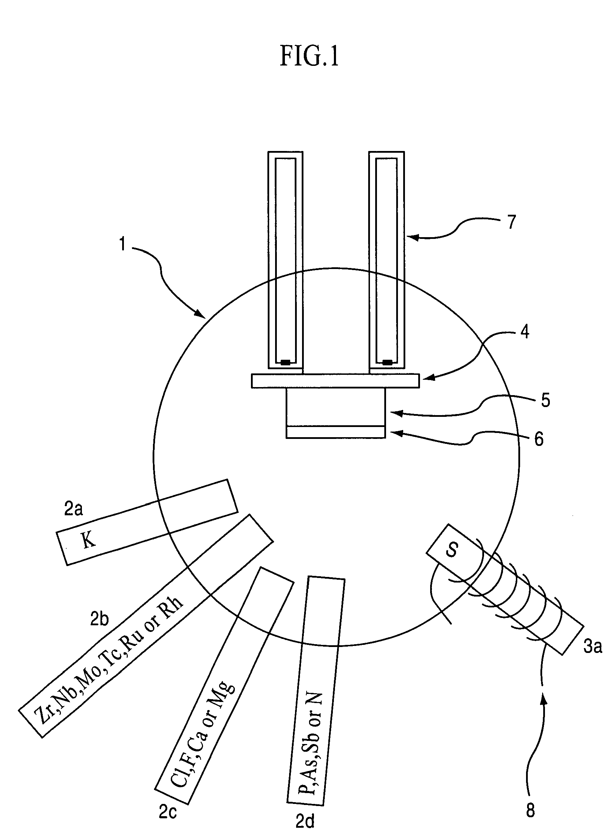

A thin film of the above alkali chalcogenide having the solid solution of the transition metal element is formed, for example, using a MBE process. As shown in an explanatory schematic diagram of FIG. 1, an apparatus for the MBE process comprises a chamber 1 designed to maintain an ultrahigh vacuum of about 1.33 × 10⁻⁶ Pa, a substrate holder 4 disposed in the chamber 1 and designed to allow a substrate 5 for growing an alkali chalcogenide, such as K₂S, to be attached onto, and a heater 7 for heating the substrate 5. The substrate 5 is made, for example, of SiC, SiO₂ or sapphire.

Further, a cell 2a receiving therein a raw material (compound source) K of elements each constituting the compound to be grown, a cell 2b receiving therein one transition metal element selected from Zr, Nb, Mo, Tc, Ru and Rh (while a single cell is illustrated in FIG. 1, two or more cells will be provided when a mixed crystal of two or more of the transition metal elements) a cell 2c receiving therein an n-type dopant, such as Cl, F, Ca or Mg, a cell 2d receiving therein a p-type dopant, such as P, As, Sb or N, and an RF radical cell 3a for generating a radical S, are disposed in opposed relation to the substrate 5 held by the substrate holder 4. Each of the solid materials, such as the K or the transition metal element, may be contained in a cell in the form of a chalcogen compound having this solid material, and used after being converted to an atomic state.

While the cells 2a to 2b for receiving therein the solids (metal elements) are not shown, each the cells is designed to heat a corresponding one of the solid sources so as to vaporize it in an atomic state. As shown FIG. 1, the radical cell 3a is designed to be activated by an RF (high-frequency) coil 8. Each of the K, the transition metal element and the n-type dopant is prepared by converting a corresponding solid source having a purity of 99.99999 % to an atomic state, and the RF radical cell 3a is activated to prepare atomic S. This apparatus is also designed to prepare atomic S by heating. Each of the K, the S and the transition metal element may be converted to an atomic state by irradiating their molecule gas with an electromagnetic wave in a microwave range.

The n-type dopant, such as Cl, F, Ca or M, and the p-type dopant, such as atomic P, As or N, and the transition element, such as Zr, Nb, Mo, Tc, Ru or Rh, in an atomic state, are simultaneously supplied on the substrate 5, respectively, at a flow rate of 1.33 × 10⁻⁵ Pa, 6.65 × 10⁻⁵ Pa and 1.33 × 10⁻⁵ Pa, while to growing K₂S at 250 to 850°C. In this manner, a K₂S film 6 incorporating the transition metal element in the form of a solid solution can be grown.

While the above description has been made based on an example where the n-type and p-type dopants are doped, FIG. 2 and after-mentioned Tables 1 and 2 relate to an example where only one of the 4d transition metal elements consisting of Zr, Nb, Mo, Tc, Ru and Rh is incorporated as a solid solution without doping the n-type and p-type dopants.

As seen in FIG. 2, when each of Zr, Nb, Mo, Tc, Ru and Rh is incorporated into the K₂S thin film 6 in the form of a solid solution at 5 at%, the K₂S thin film 6 having each of the solid solutions of Zr, Nb, Mo, Tc, Ru and Rh has a large difference ΔE between the entire energy in an antiferromagnetic spin-glass state and the entire energy in a ferromagnetic state, specifically, 0.39 × 13.6 meV for Zr, 0.38 × 13.6 meV for Nb, 0.3× 13.6 meV for Mo, 0.1 × 13.6 meV for Tc, 0.2× 13.6 meV for Ru, and 0.28 × 13.6 meV for Rh. That is, the K₂S thin film 6 has a stable ferromagnetic state. In the K₂S thin film 6 having the solid solution of Mo, the antiferromagnetic spin-glass state becomes stable by - 0.39 × 13.6 meV.

In this way, a transparent ferromagnetic semiconductor exhibiting a ferromagnetic state or an antiferromagnetic state can be selectively formed in a desired magnetic state according to an intended purpose by changing an atomic species to be doped.

While this example has shown the K₂S compound having each solid solution of the transition elements, an compound with an anti-fluorite structure, such as K₂Se, K₂Te, K₂O, Na₂S, Na₂Se, Na₂Te, Na₂O, Li₂O, Li₂S, Li₂Se, Li₂Te, Rb₂O, Rb₂S, Rb₂Se, Rb₂Te Cs₂O, Cs₂S, Cs₂Se and Cs₂Te (hereinafter referred to as "K₂S-series compound"), may be used in place of K₂S. These compounds can be controlled to change their bandgap energy. Further, these compounds are common in terms of an anti-fluorite structure, and different only in bandgap. Thus, they are different only in wavelength for transmission of light. As with K₂S having each solid solution of the transition metal elements, a completely-spin-polarized (half metallic) transparent ferromagnetic semiconductor can be obtained from these compounds in the form of a single crystal.

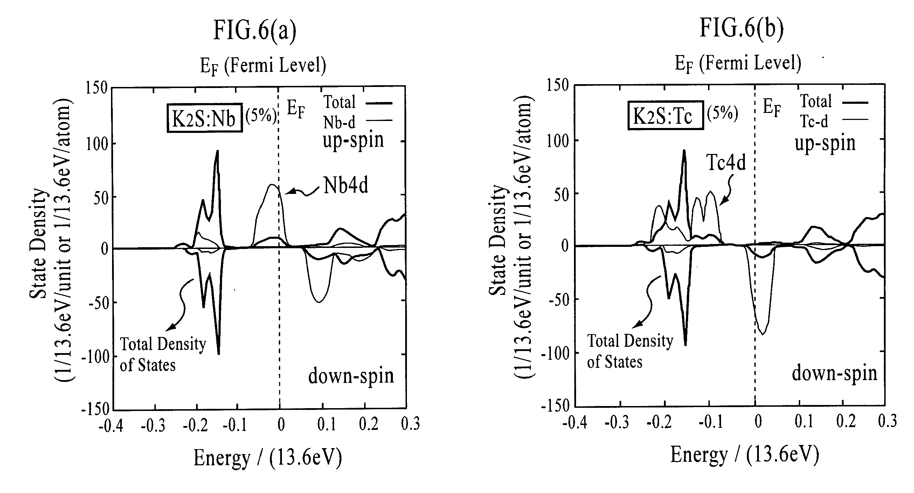

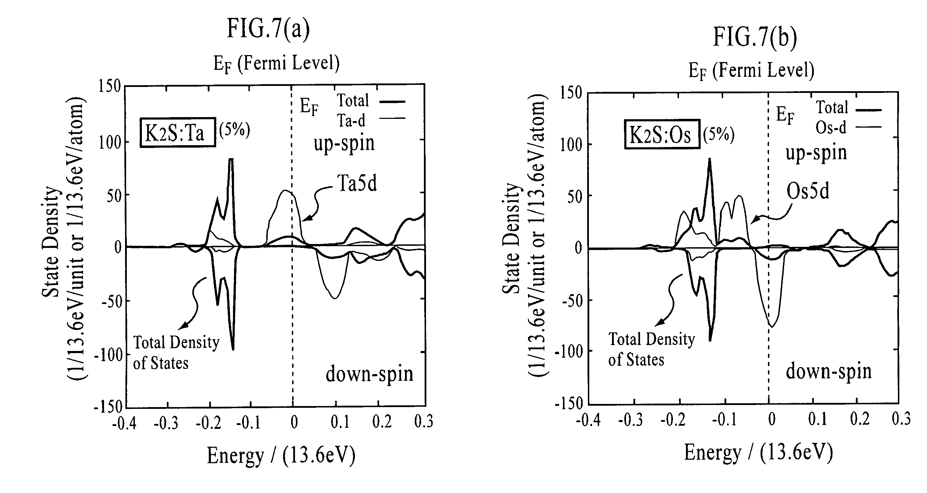

As shown in FIGS. 6 and 7, in the half metallic state, an electronic state exists only in one of two spin directions in the Fermi level, and, in the other or opposite spin direction, a bandgap opens or the electronic state cannot exist at the Fermi level. This means that 100%-spin-polarized itinerant electrons move around a substance. Thus, the compound of the present invention can be used in a process of injecting spins into another substance, and an insulating material can be sandwiched between the compounds of the present invention to provide a material essential to development of devices for a magnetic memory or a processor utilizing complete-spin-polarization.

The anti-fluorite structure of the completely-spin-polarized half-metallic transparent ferromagnetic K₂S-series compound of the present invention is maintained even after K⁺ is substituted with one of Zr⁺, Nb⁺, Tc⁺, Ru⁺ and Rh⁺. In addition, the transition metal element of Zr, Nb, Mo, Tc, Ru or Rh has an electronic structure where itinerant electrons and holes moves within the impurity band, and thereby a ferromagnetic state is stabilized in the state after the formation of the solid solution of transition metal element without doping a hole or electron, as shown in FIG. 2.

Further, this half-metallic transparent ferromagnetic K₂S-series compound has a large magnetic moment, as in Tables 1 and 2 described in detail later. For example, a Nb or Tc-solid solution-containing K₂S-series compound having a magnetic moment of 3.94 × 9.274 J/T [3.94 µ_{B} (Bohr magneton)] can be obtained. Further, a strongly/completely-spin-polarized transparent ferromagnetic magnet having a strong magneto-optical characteristics based on a large spin-orbital interaction and an extremely strong magnetic anisotropy can be obtained.

The change of a magnetic characteristic to be caused by changing a concentration of the transition metal element was checked. In addition to the above thin film having the aforementioned solid solution of the transition metal element incorporated therein at a concentration of 5 at%, films having the solid solution at a concentration of 10, 15, 20 and 25 at% were prepared, and each magnetic moments (× 9.247 J/T) and ferromagnetic transition temperature (degree K) of the films were checked. The magnetic moment and the ferromagnetic transition temperature were obtained from measurement of a magnetic susceptibility using a SQUID (superconducting quantum interference device). The result is shown in Tables 1 and 2.

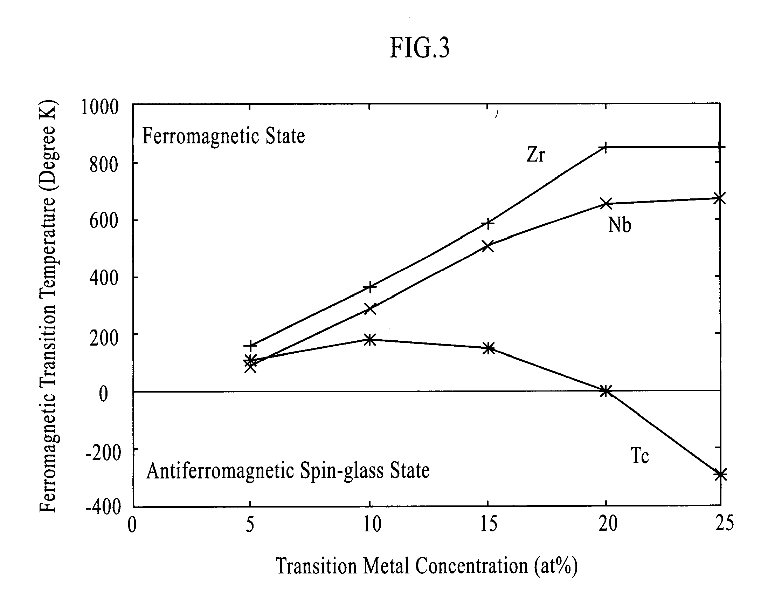

As evidenced by Tables 1 and 2, the ferromagnetic transition temperature is apt to increase as a concentration of the transition metal element becomes higher, and to increase as a percentage of the solid solution is increased. FIG. 3 shows changes of the ferromagnetic transition temperature caused when a concentration of the transition metal element to be incorporated into K₂S in the form of a solid solution is changed. As seen in FIG. 3, a ferromagnetic interspin interaction also increases along with increase in the concentration of the transition metal element.

**Table 1**

| Transition Metal | Concentration of Transition Metal (at %) | Magnetic Moment (µB) | Ferromagnetic Transition Temperature (degree K) |
|---|---|---|---|
| Zr | 5 | 2.84 | 593 |
| Nb | 5 | 3.95 | 572 |
| Tc | 5 | 3.92 | 216 |

**Table 2**

| Transition Metal | Concentration of Transition Metal (at %) | Magnetic Moment (µB) | Ferromagnetic Transition Temperature (degree K) |
|---|---|---|---|
| Zr | 20 | 2.69 | 820 |
| Nb | 20 | 3.64 | 626 |
| Tc | 20 | 3.86 | 359 |

As described above, the transition metal element has a high spin state with an electron spin s = 3/2, 2, 2. As is clear from Tables 1 and 2 and FIG. 3, it is proven that the ferromagnetic interspin interaction and the ferromagnetic transition temperature can be controllably adjusted by changing the concentration of the transition metal element. From a practical standpoint in consideration of application to spin electronics operating at room temperature, the ferromagnetic transition temperature is preferably adjusted at 300 degrees K or more.

The inventors further found that, two or more of the transition metal elements can be added to form a mixed crystal thereof so as to adjust the state of holes or electrons and have a combined magnetic characteristic specific to the respective transition metal elements. As one example, Zr, Nb and Mo were added to form a mixed crystal thereof, and "x" in Nb_{0.25-x} MoₓK_{1.75} S was variously changed under the condition that a total content of Zr and Mo, Nb and Mo or Tc and Mo was set at 25 at%.

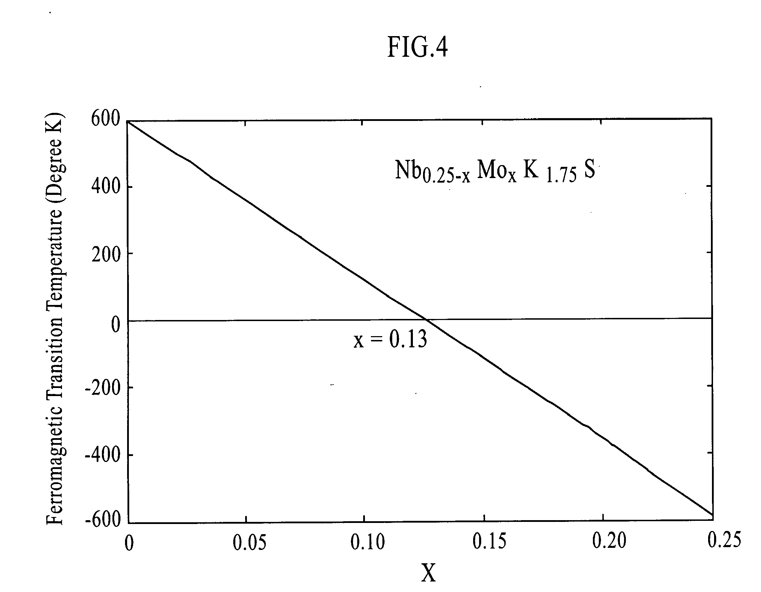

The result is shown in FIG. 4. FIG. 4 is an explanatory graph showing changes of a ferromagnetic transition temperature when a mixed crystal is formed by adding two or more of the transition metal elements while changing a ratio of the transition metal elements. As shown in FIG. 1, the ferromagnetic transition temperature can be largely changed. Specifically, the ferromagnetic transition temperature can be set at zero degree K when x = 0.13, and set at a desired value by selecting "x" in the range of zero to 0.25. Further, Zr, Ru and Mo may be added in a total content of 25 at% in the same manner to form a mixed crystal thereof, and "x" in Zr_{0.25-x} MoₓK_{1.75} S or Ru_{0.25-x} MoₓK_{0.75} S_{0.5} may variously changed. Although not illustrated, as to a magnetic moment, a value depending on the mixing ratio between two of the Zr, Ru and Mo can be obtained.

While a ferromagnetic characteristic in the above example is changed by adding two or more of the transition metal elements to form a mixed crystal thereof, n-type dopant and/or a p-type dopant may be doped to similarly change the number of holes or electron so as to change a ferromagnetic state.

In this case, a hole or an electron introduced by the n-type or p-type dopant enters into an impurity band strongly hybridized with a d-orbital of the transition metal and a p-orbital of K₂S formed in a bandgap of K₂S to change a ferromagnetic state and a ferromagnetic transition temperature. For example, the doping of the n-type dopant means to supply an electron, and the n-type dopant can be doped into Zr or Nb exhibiting ferromagnetic properties to obtain the same effect as that of the addition of Mo to Zr or Nb. Further, the p-type dopant can be doped into Tc, Ru or Rh exhibiting ferromagnetic properties to obtain the same effect as that of the addition of Mo to Tc, Ru or Rh.

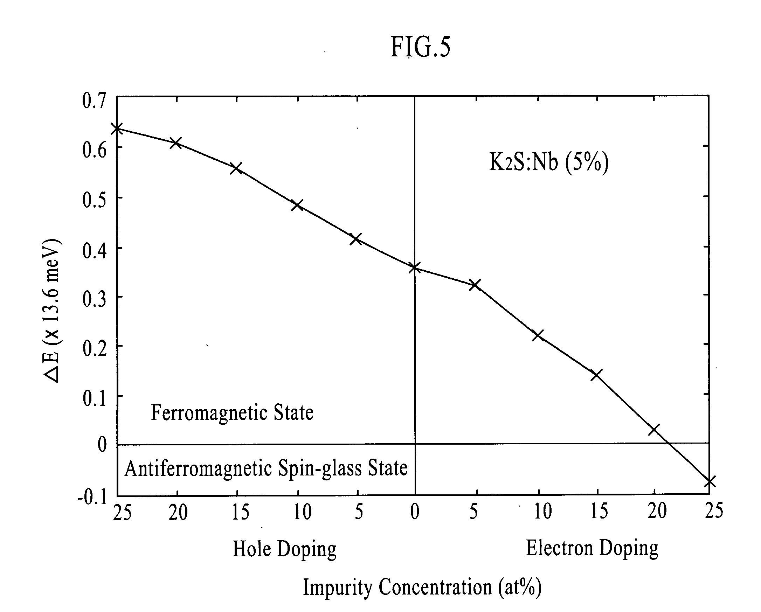

For example, given that the p-type dopant is doped into Nb or Zr having significant changes in ΔE which is a difference between the entire energy in an antiferromagnetic spin glass state and the entire energy in a ferromagnetic state to be caused by doping of the n-type dopant or the p-type dopant (doping of a hole), a relation between the ΔE and a concentration (at%) of the p-type dopant is shown in FIG. 5. FIG. 5 is an explanatory graph showing changed of a magnetic state when n-type and p-type dopants is added into Nb as one example. As seen in FIG. 5, the ferromagnetic state is stabilized by doping the hole, and erased by doping an electron from the n-type dopant. In this manner, the ferromagnetic can be adjusted.

While Tc, Ru and Rh in the 4d transition metal element originally exhibit ferromagnetic properties, the hole doping can reversely destabilize a ferromagnetic state and lower a ferromagnetic transition temperature to cause transition to a spin-glass state. Further, the ferromagnetic transition temperature can be adjusted by changing a concentration of the p-type dopant.

Cl, F, Ca or Mg may be used as the n-type dopant, and a chalcogen compound thereof may be used as a doping material. Preferably, the donor has a concentration of 1 × 10¹⁸ cm⁻³ or more. For example, when the donor is doped at a concentration about 10²⁰ to 10²¹ cm⁻³, the effect of the doping is equivalent to the aforementioned solid-solution incorporated at ratio of about 1 to 10 at%. At to the p-type dopant, P, As, Sb or N may be used therefor, as described above. In this case, while the p-type dopant has difficulty in doping, a small amount of the n-type dopant may be codoped to allow the p-type dopant to be doped in a higher concentration.

Through further researches, the inventors found that a lower-limit wavelength for transmission of light is varied depending on changes in bandgap energy and d electron caused by changing kind of the transition metal element to be incorporated into an alkali chalcogen compound in the form of a solid solution, and the lower-limit wavelength for transmission of light can be adjusted by mixing of two or more of the transition metal elements to be incorporated as a solid solution, so as to form a light filter for cutting light with a desired wavelength or less.

That is, a ferromagnetic alkali chalcogenide transparent only to light having a desired wavelength is obtained. A lower-limit wavelength for transmission of light in K₂S having a solid solution of each of the transition metal elements incorporated therein at 25 at% is shown in Table 3. As seen in Table 3, this K₂S is provided as a ferromagnetic magnet transparent to light with a desired wavelength.

**Table 3**

| Transition metal | Concentration of Transition Metal (at %) | Lower-Limit Wavelength (nm) |
|---|---|---|
| K₂S : Zr | 25 | 320 |
| K₂S : Nb | 25 | 260 |
| K₂S : Ru | 25 | 380 |

As mentioned above, according to the present invention, the entire energy in a ferromagnetic state can be changed based on kinetic energy of a hole or electron introduced by the metal element introduced as a solid solution, and the hole or electron to be introduced is adjusted. Thus, the ferromagnetic state can be stabilized.

Further, the strength and sign of a magnetic interaction between the transition metal elements are largely changed based on the introduced hole or electron. Thus, the hole and electron is adjusted to control the strength and sign of a magnetic interaction so as to stabilize the ferromagnetic state or reversely erase the ferromagnetic state and induce transition to an antiferromagnetic spin-glass state.

While the MBE (molecular beam epitaxy) apparatus has been used in the above example as a means to form an alkali/chalcogenide thin film having a solid solution of the transition metal element, a MOCVD (metalorganic chemical vapor deposition) apparatus may be used to form the same film. In this case, the metal element, such as the alkali metal element, e.g. K or Na, or the transition metal element is introduced in the MOCVD apparatus, in the form of an organic metal compound, such as dimethyl potassium or dimethyl sodium.

According to a MBE process or a MOCVD process using the above apparatus, the thin film can be formed in a non-equilibrium state to allow the transition metal element to be added at a desired concentration. The film-forming process is not limited to these processes, but may be a laser abrasion process of spraying an activated dopant onto a substrate using as a target a solid body of the alkali chalcogen compound and a solid metal of the transition metal element to form a film.

Further, when a transition metal element or a chalcogen compound thereof is use as a raw material, an ECR plasma may be used that is designed to be electronically excited by radio waved, leaser, X-ray or electron beam so as to convert the raw material to an atomic state. The ECR plasma may also be used for the n-type and/or p-type dopants. The ECR plasma has an advantage of being able to convert the dopants to an atomic state and add them in a high concentration.

In a material added with Tc serving as a completely-spin-polarized transparent ferromagnetic material, Tc has a life-duration of 10000 years or more according to measurement of beta decay, and emits gamma radiations and electrons for the duration. Such a completely-spin-polarized material will continuously emit 100%-spin-polarized electrons. Thus, the material can be used as a spin injection source or a spin buttery having no need for a spin-buttery source, a buttery and power source.

### INDUSTRIAL APPLICABILITY

According to the present invention, a completely-spin-polarized transparent ferromagnetic single crystal can be obtained only by incorporating a transition metal element or lanthanum-series rare-earth element having large magneto-optical effects, into an alkali/ chalcogenide compound in the form of a solid solution. Thus, the transparent ferromagnetic single crystal can be combined with an existing ZnO or transparent conductive oxide (TCO) used as an n-type or p-type transparent electrode, or fiber optics, and then applied to a quantum computer or large-capacity magneto-optical recordings. Further, the transparent ferromagnetic single crystal can also applied to high-performance information communications or a quantum computer, as an optical electronics material usable from visible to ultraviolet range.

## Claims

1. A single-crystal transparent ferromagnetic alkali chalcogenide comprising an alkali chalcogen compound which has an anti-fluorite structure and contains at least one metal element selected from a 4d transition metal element group consisting of Zr, Nb, Mo, Tc, Ru and Rh, said selected metal element being incorporated in said alkali chalcogen compound in the form of a solid solution to provide a ferromagnetic characteristic thereto.

2. A single-crystal transparent ferromagnetic alkali chalcogenide comprising an alkali chalcogen compound which has an anti-fluorite structure and contains at least one metal element selected from a 5d transition metal element group consisting of Hf, Ta, W, Os, Re and Ir, said selected metal element being incorporated in said alkali chalcogen compound in the form of a solid solution to provide a ferromagnetic characteristic thereto.

3. A single-crystal transparent ferromagnetic alkali chalcogenide comprising an alkali chalcogen compound which has an anti-fluorite structure and contains at least one metal element selected from a lanthanum-series rare-earth element group consisting of Ce, Pr, Nd, Pm, Sm, Eu, Gd, Tb, Dy, Ho, Er, Tm, Yb and Lu, said selected metal element being incorporated in said alkali chalcogen compound in the form of a solid solution to provide a ferromagnetic characteristic thereto.

4. A single-crystal transparent ferromagnetic alkali chalcogenide comprising an alkali chalcogen compound which has an anti-fluorite structure and contains at least one metal element selected from a 3d transition metal element group consisting of Ti, V, Cr, Mn, Fe, Co, Ni and Cu, said selected metal element being incorporated in said alkali chalcogen compound in the form of a solid solution to provide a ferromagnetic characteristic thereto.

5. The transparent ferromagnetic alkali chalcogenide as defined in either one of claims 1 to 4, wherein at least two metal elements selected from one or more of said 3d transition metal element group, said 4d transition metal element group, said 5d transition metal element group and said lanthanum-series rare-earth element group, are formed as a mixed crystal.

6. The transparent ferromagnetic alkali chalcogenide as defined in either one of claims 1 to 5, which is doped with at least one of an n-type dopant and a p-type dopant.

7. A method of adjusting the ferromagnetic characteristic of the transparent ferromagnetic alkali chalcogenide as defined in either one of claims 1 to 6 comprising: adding at least one metal element selected from said 3d transition metal element group, said 4d transition metal element group, said 5d transition metal element group and said lanthanum-series rare-earth element group, to an alkali chalcogenide in such a manner as to be incorporated thereinto in the form of a solid solution, wherein a concentration of said added metal element is adjusted to adjust said ferromagnetic characteristic.

8. A method of adjusting the ferromagnetic characteristic of the transparent ferromagnetic alkali chalcogenide as defined in either one of claims 1 to 6 comprising adding at least one metal element selected from said 3d transition metal element group, said 4d transition metal element group, said 5d transition metal element group and said lanthanum-series rare-earth element group, to an alkali chalcogenide in such a manner as to be incorporated thereinto in the form of a solid solution, wherein a combination of said at least two metal elements is selected to adjust said ferromagnetic characteristic.

9. The method as defined in claim 7 or 8, which including further adding at least one of an n-type dopant and a p-type dopant to said alkali chalcogenide.

10. The method as defined in either one of claims 7 to 9, wherein said ferromagnetic characteristic is a ferromagnetic transition temperature.

11. The method as defined in claim 8, wherein said combination for adjusting the ferromagnetic characteristic is selected to adjust an energy amount in a ferromagnetic state and adjust the number of carriers, based on a hole of electron to be introduced by said metal elements themselves, so as to relatively reduce the entire energy amount in ferromagnetic and/or spin-glass states to stabilize and create desired ferromagnetic and/or spin-glass states.

12. The method as defined in claim 8, wherein said combination is selected to control a strength and sign of a magnetic interaction between metal atoms, based on a hole or electron to be introduced by said added transition metals themselves, so as to stabilize a ferromagnetic state.

13. The method as defined in claim 8, wherein said combination is selected to control a strength and sign of a magnetic interaction between metal atoms, based on a hole or electron to be introduced by said added transition metals themselves, and control a light-transparency, based on solid solution of the transition metal elements, so as to provide a desired light-filter characteristic to said transparent ferromagnetic alkali chalcogenide.
